# EUROPÄISCHE PATENTSCHRIFT

(11) **EP 1 072 096 B1**
(45) Veröffentlichungstag und Bekanntmachung des Hinweises auf die Patenterteilung: **16.10.2002**
(21) Anmeldenummer: 99919106.7
(22) Anmeldetag: 20.03.1999
(51) Int. Cl.: H03K 19/0175, G06F 13/40

(54) **FREMDVERSORGTER SCHNITTSTELLENADAPTER**
EXTERNALLY SUPPLIED INTERFACE ADAPTER
ADAPTATEUR D'INTERFACES A ALIMENTATION EXTERNE

(30) Priorität: 20.03.1998 DE 19812422; 20.04.1998 DE 19817441
(43) Veröffentlichungstag der Anmeldung: 31.01.2001
(73) Patentinhaber: Moeller GmbH, 53115 Bonn (DE)
(72) Erfinder: CULCA, Horea-Stefan, D-53797 Lohmar (DE)
(86) Internationale Anmeldenummer: DE9900802
(87) Internationale Veröffentlichungsnummer: WO99049577

(56) Entgegenhaltungen:
- DE-A- 4 422 465
- DE-A- 19 514 888
- DE-A- 19 620 820
- US-A- 5 402 015
- US-A- 5 555 421
- "goedkope galvanische scheider voor RS232" ELEKTUUR,Juli 1997 (1997-07), Seite 89 XP002102753

## Beschreibung

Die Erfindung betrifft einen Umsetzer für die digitale Datenübertragung zwischen einer elektrischen Schnittstelle eines ersten Gerätes und einer elektrischen Schnittstelle eines zweiten Gerätes, wobei die Geräte jeweils unterschiedliche Spannungslevel zur Unterscheidung der beiden logischen Zustände "high" und "low" benutzen.

Wenn zwei elektronische Geräte mittels Datenübertragung miteinander kommunizieren, müssen sie dieselbe Sprache sprechen. Bei der direkten Übertragung digitaler Daten bedeutet dies, daß die logischen Zustände "high" und "low" bei beiden Geräten durch dieselben Spannungslevel repräsentiert sein müssen.

Aus dem Artikel "goedkope galvanische scheider voor RS232", ELEKTUUR, July 1997 (1997-07), Seite 89 XP002102753, ist ein gattungsgemäßer Umsetzer für digitale Datenübertragung für den Standard RS232 bekannt. Dieser Umsetzer beinhaltet eine spezielle Ausführung einer galvanischen Trennung bei einer RS232 Schnittstelle. Bei dieser Ausführung werden die Schaltglieder zur Generierung der zu übertragenden Signale durch eine Spannung versorgt, die durch zusätzliche Schaltungsteile erst einmal erzeugt werden muß. Desweiteren ist eine zusätzliche Spannungsversorgung der eingangsseitigen Schaltungsteile des Schaltgliedes erforderlich.

In der digitalen Datenübertragung werden u.a. zwei Normen benutzt. Die eine Norm ist die RS 232 mit Signalen, die den Zustand "high" mit Pulsen einer Spannung von etwa -12 Volt und den Zustand "low" mit Pulsen einer Spannung von etwa +12 Volt kennzeichnen. Derartige seriellen Schnittstellen werden bevorzugt bei Rechenanlagen wie Personal Computern (PC) eingesetzt. Viele von Computern ansteuerbare elektronische Geräte, z.B. Steuergeräte für Motoren, Schalteinrichtungen oder speicherprogrammierbare Steuerungen, erzeugen und benötigen für die Kommunikation Pulse der TTL-Norm mit Signalstärken von etwa 0 Volt für den einen und etwa +5 Volt für den anderen Zustand.

Für die Kommunikation zwischen zwei elektronischen Geräten, die mit unterschiedlichen Spannungsleveln arbeiten, müssen die Signale transformiert werden. So müssen im Falle der Transformation von Signalen der TTL-Norm die positiven Signale auf -12 Volt umgesetzt werden. Diese Verstärkung der Signale ist insoweit technisch aufwendig, als dazu externe Spannungsquellen nötig sind. Die Herabsetzung der Signalstärke kann hingegen im Falle der RS 232 und der TTL-Norm durch einfaches Sperren der Spannung mittels einer Diode bzw. durch Heruntertransformation der Spannung geschehen.

Auch wenn die Verstärkung der Signale keine prinzipiellen Probleme mit sich bringt, so ist es gerade bei Kleingeräten aus Kostengründen und wegen der Platzersparnis vorteilhaft, wenn auf derartige Spannungsumsetzer verzichtet werden kann, zumal wenn die Kommunikation mit anderen Geräten im Betrieb eine untergeordnete Rolle spielt. Für derartige Kleingeräte sind fremdversorgte Schnittstellenadapter bekannt, die einen Stecker aufweisen, in dessen Gehäuse eine Umsetzerschaltung mit Verstärkern untergebracht ist. Dieser Schaltung wird von außen eine höhere Spannung zugeführt. Schnittstellenadapter diser Art sind wegen der Verstärkerschaltung vergleichsweise aufwendig und führen zu einer zusätzlichen Kostenbelastung elektronischer Geräte, die auf eine billige Massenfertigung ausgelegt sind.

Aufgabe der Erfindung ist es, einen Schnittstellenadapter zu schaffen, der mit geringem technischen Aufwand kostengünstig herstellbar ist.

Diese Aufgabe wird durch einen Umsetzer für die digitale Datenübertragung mit den kennzeichnenden Merkmalen des Anspruch 1 gelöst.

Mit dem erfindungsgemäßen Umsetzer ist eine baulich einfache und damit preisgünstige Möglichkeit geschaffen, eine elektrischen Schnittstelle, z.B. die serielle Schnittstelle eines Mikrocomputers, mit der elektrischen Schnittstelle eines anzusteuernden Gerätes bei gleichzeitiger Umsetzung der zur Unterscheidung der logischen Zustände "high" und "low" dienenden Signallevel zu verbinden. Wegen der Zuführung des höheren Spannungslevels von einem der beiden Geräte, nämlich von dem Gerät, das "on-board" eine RS 232 Schnittstelle hat, insbesondere von einem PC, kann vollständig auf eine externe Spannungsversorgung verzichtet werden. Erfindungsgemäß stellt das eine der beiden Geräte dem Umsetzer den benötigten Spannungslevel selbst zur Verfügung. Der Umsetzer zeichnet sich dabei durch seine einfachen Bauteile aus und ist besonders robust und zuverlässig, da er die für den Transfer von Daten zwischen verschiedensprachigen mechanischen Schnittstellen nötigen Funktionen in sich vereint.

Der Umsetzer (Schnittstellenadapter) kann in einer besonders vorteilhaften Ausführungsform in einen Stecker integriert werden, der sich an dem die beiden Geräte verbindenden Datentransferleitung befindet, er kann aber auch in einem der Geräte selber untergebracht werden. Wegen seiner billigen Bauweise trägt er zur Vereinfachung der Geräte und damit zu einer Preissenkung bei.

Besonders vorteilhaft ist es, wenn die interne Schaltung die Umsetzung des niedrigeren Levels auf den höheren Level durch einen einfachen vom Signal mit niedrigerem Level initiierten Umschaltvorgang bewerkstelligt. Durch den Umschaltvorgang wird der dem Adapter von einem Gerät zugeführte höhere Spannungslevel auf die Datenleitung gelegt. Die aufwendige Verstärkung wird erfindungsgemäß durch einen einfachen Schaltvorgang ersetzt, was insofern zu einer weiteren vereinfachung des Schnittstellenadapters beiträgt, als sich die positiven und negativen Versorgungsspannungen erübrigen. Der Schaltvorgang wird dabei mittels eines Schaltgliedes ausgeführt, das durch den Zustand der Datenleitung des ersten Gerätes steuerbar ist und das je nach logischem Zustand der Datenleitung eine der beiden von dem zweiten Gerät zugeführten Leitungen auf den Dateneingang des zweiten Gerätes durchschaltet.
In einer vorteilhaften Ausführung setzt die interne Schaltung Signale der TTL-Norm von 0 Volt bzw. von +5 Volt auf Signale der RS 232 Norm um. Eine solche Konvertierung wird häufig bei der Kommunikation eines mit einer RS 232 Schnittstelle bestückten PCs mit einem externen Gerät benötigt. Da die RS 232 Schnittstelle neben den Datenleitungen noch über andere Leitungen, wie z.B. der "Request to Send" (RTS) und der "Data Terminal Ready" (DTR) Leitung verfügt, ist es vorteilhaft, diese vorhandenen schon Leitungen zu nutzen, um dem Schnittstellenadapter die Spannungslevel von insbesondere +/- 12 Volt zuzuführen. Diese für die Kommunikation mit der TTL Schnittstelle nicht benötigten Leitungen können ohne großen Aufwand über ein auf dem Rechner laufendes Programm auf die generell vom Rechner bereitgestellten Spannungen von +/- 12 Volt gelegt werden. In diesem Falle schaltet das Schaltglied die entsprechende Spannung einfach von der RTS bzw. der DTR Leitung auf die Datentransferleitung durch.

In einer besonders einfachen Ausführung ist das Schaltglied ein Schalter mit zwei Eingängen und einem Ausgang, wobei die Eingänge mit den auf +/- 12 Volt liegenden Leitungen der RS 232 Schnittstelle und der Ausgang mit der Eingangs-Datentransferleitung verbunden ist und zwischen den beiden Ausgängen hin und her geschaltet werden kann.

Besonders vorteilhaft wird der erfindungsgemäße Adapter zur externen Programmierung speicherprogrammierbarer Steuerungen mit integrierter Recheneinheit (Microcontroler), einem Bildschirm (Display) und einer Bedieneinheit eingesetzt, wobei die Steuerung zusätzlich über eine mechanische Schnittstelle verfügt. Da diese Steuerungen auch ohne externe Programmierung viele Einsatzmöglichkeiten bieten, kann die Elektronik zur Signalkonvertierung inerhalb der Steuerung durch den Adapter ersetzt werden. Damit wird die Steuerung billiger, kompakter und zuverlässiger. Der Anwender spart die Verstärkerschaltung in der Steuerung und braucht nur dann einen Adapter anzuschaffen, wenn er eine externe Programmierung durchführen möchte.
Vorteilhafterweise wird in den Adapter eine galvanische Trennung der beiden Geräte integriert, so daß in den Geräten auf entsprechende Bauteile verzichtet werden kann. Dazu weist die interne Schaltung ein Koppelglied für die galvanische Trennung auf. Als Koppelglieder bieten sich einfache und preiswerte Optokoppler an, die in beliebigen Varianten auf dem Markt verfügbar sind. Derartige Optokoppler eignen sich auch für die Konvertierung der +12 Volt Signale auf den TTL Level von +5 Volt. Die Konvertierung in dieser Richtung wird vorteilhafterweise gleichfalls durch die interne Schaltung bewerkstelligt. Zur Konvertierung des Signals der Stärke -12 Volt auf den TTL Level von 0 Volt wird die interne Schaltung voreilhafterweise mit einem Sperrglied, beispielsweise in Form eine einfachen Diode, versehen.

In einer besonders einfachen Ausführungsform ist die interne Schaltung in einem aus Kunststoff gespritzen Gehäuse untergebracht, das als Stecker direkt auf die mechanische Schnittstelle von einem der beiden Geräte aufsetzbar ist. Der Weg zur anderen Schnittstelle wird mittels eines Kabels zur Datenleitung überbrückt.

Ein Ausführungsbeispiel des erfindungsgemäßen Adapters ist in den Zeichnungen 1 bis 4 dargestellt und wird im folgenden näher beschrieben. Es zeigen
- **Figur 1**: eine speicherprogrammierbare Steuerung mit Schnittstellenadapter und externem Rechner
- **Figur 2**: eine Schaltskizze des fremdversorgten Schnittstellenadapters,
- **Figur 3**: eine Schaltung für niedrige Übertragungsgeschwindigkeiten und
- **Figur 4**: eine Schaltung für unterschiedliche Verzögerungszeiten der Optokoppler.

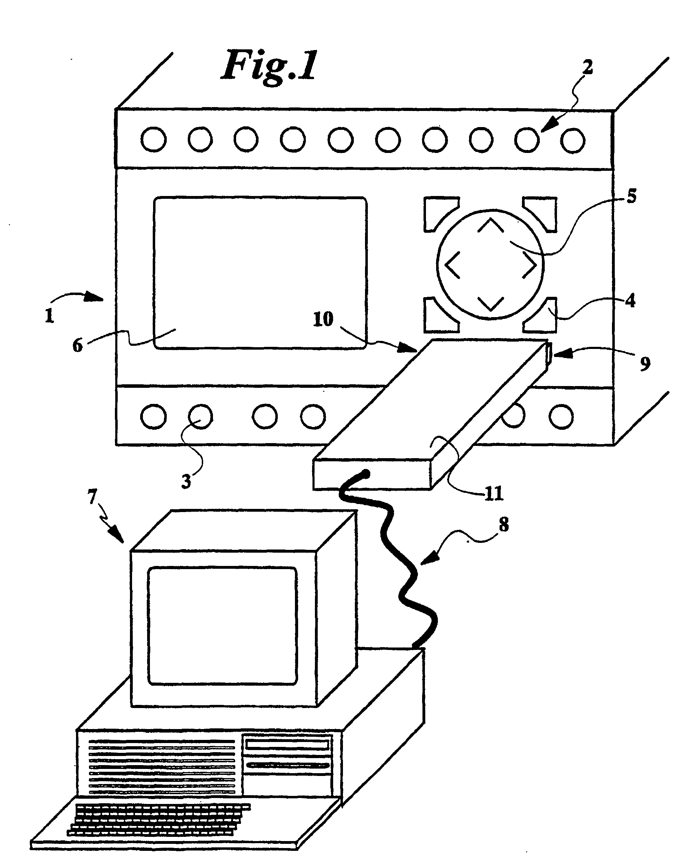

In Figur 1 ist eine speicherprogrammierbare Steuerung mit einem Gehäuse 1 und mit einer Reihe von Spannungseingängen 2 und Signalausgängen 3 dargestellt. Die Steuerung schaltet unter Kontrolle eines Schaltprogrammes den Stromfluß zwischen den Eingängen 2 und den Ausgängen 3. Das Programm kann der im Gehäuse 1 untergebrachten Recheneinheit einerseits mittels der Bedientasten 4 und der Mehrfunktionstaste 5 eingegeben werden, wobei die Eingabe und der Programmablauf auf dem Bildschirm 6 beobachtbar sind. Während der Programmierung und bei der Bedienung des Gerätes ist auf dem Bildschirm 6 eine menuegeführte Benutzeroberfläche dargestellt.

Andererseits ist es möglich, die Steuerung von einem externen Rechner 7 zu programmieren. Dazu sind der Rechner 7 und die Steuerung über eine Datenleitung 8 verbunden, die rechnerseits in eine nicht dargestellte Schnittstelle RS 232 auf der Rückseite des Rechners und seitens der Steuerung in eine Schnittstelle 9. Auf die Schnittstelle 9 der Steuerung ist ein fremdversorgter Schnittstellenadapter 10 aufgesetzt, der als Stecker mit einem Gehäuse 10a und einem normierten Steckerkopf ausgebildet ist.

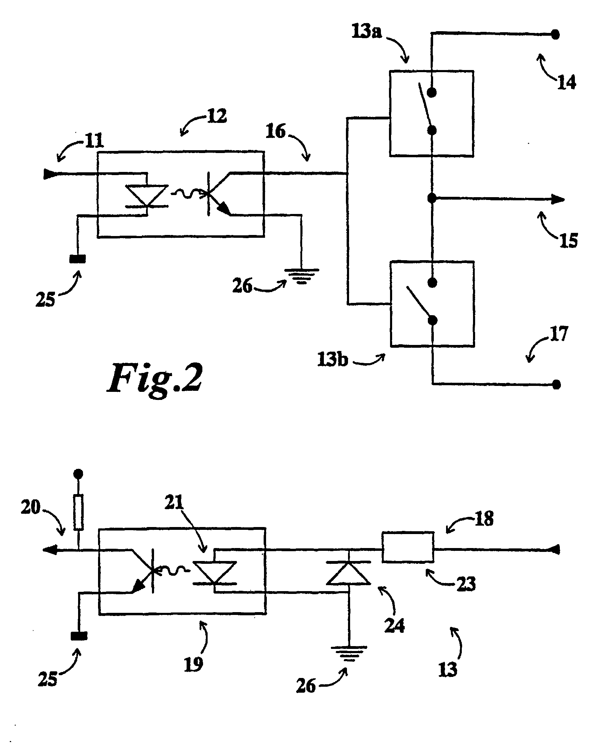

Figur 2 zeigt die interne Schaltung 23 des Schnittstellenadapters 10. Auf der rechten Seite der Figur 2 sind die Anschlüsse zur Schnittstelle des Rechners und auf der linken Seite die Anschlüsse zur Schnittstelle 9 der Steuerung dargestellt. Auf Seiten der Steuerung führt eine Sendeleitung (TxD) 11 für ein TTL-Signal von 5 Volt in einen Optokoppler 12. Das 5 Volt Signal auf Leitung 11 führt zu einem davon galvanisch getrennten ersten Signalzustand auf einer Leitung 16 und zu von dieser anzusteuernden zwei Schaltern 13a und 13b. Im dargestellten Zustand ist der Schalter 13a geschlossen und verbindet zwei von der RS 232 des Rechners kommende Leitungen 14 und 15 miteinander. Der Rechner ist derart programmiert, daß auf der Leitung 14 (RTS-Leitung) eine Spannung von 12 Volt anliegt. Durch die Verbindung wird diese Spannung auf die Leitung 15, den Eingang RxD der Schnittstelle gelegt. Der Schalter 13a bleibt für die Dauer des ersten Signalzustandes auf Leitung 16 geschlossen, so daß ein entsprechend langer 12 Volt Puls auf der Leitung 15 liegt.

Wenn auf Sendeleitung 11 die Spannung auf 5 Volt steigt, was einem logischen Zustand von "high" in der TTL-Norm entspricht, wird auf Leitung 16 ein zweiter Signalzustand erzeugt, der Schalter 13a öffnet und den Schalter 13b schlißt. Der Schalter 13b schafft dann eine Verbindung zwischen den Leitungen 15 und 17 der RS 232, wobei der Rechner so programmiert ist, daß auf Leitung 17, dem Ausgang DTR, eine konstante Spannung von -12 Volt liegt. Während des "low" Pegels auf Leitung 11 der Schnittstelle 9 wird das Signal von -12 Volt auf den Eingang TxD der RS 232 gelegt. Auf die dargelegte Weise wird eine TTL Pulsfolge der Steuerung in eine entsprechende RS 232-Pulsfolge für den Rechner konvertiert.

Der Adapter weist zudem eine Schaltung zur Konvertierung der Signale von Rechner zur Steuerung auf. Dabei kann das auf Leitung 18, der Leitung RxD der RS 232, anliegende Signal direkt einem Optokoppler 19 zugeführt werden. Signale des Rechners von +12 Volt setzt der Optokoppler 19 auf 0 Volt auf der RxD Leitung 20 der Steuerung um. Ein Signal von -12 Volt auf Leitung 18 wird durch die Diode 21 gesperrt, so daß auf Leitung 20 etwa +5 Volt für den TTL Zustand "high" anliegt. Zur Strombegrenzung ist in die Leitung 18 ein Widerstand 23 eingebracht. Eine Diode 24 dient zum Schutz der Optokopplerdiode bei negativem Signal.

Wegen deren galvanischer Trennung ist zwischen der Erdung des Gerätes 25 und der Erdung 26 des PC zu unterscheiden.

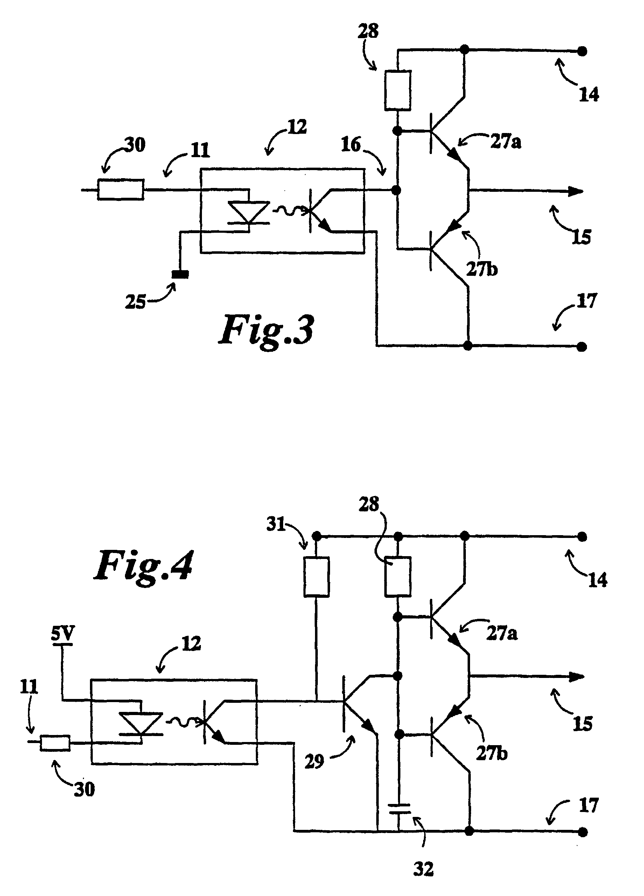

Eine Ausführungsform der Schaltung 12, 13a und 13b wird besonders einfach und preiswert mittels Transistoren realisiert. Figur 3 zeigt eine Schaltung mit galvanischer Trennung. Die Schaltglieder 13a und 13b sind mittels der Transistoren 27a und 27b realisiert. Die Ansteuerung erfolgt direkt vom Ausgangstransistor des Optokopplers 12 mittels des Basis-Versorgungswiderstandes 28.

Ist das Sendesignal TxD im Gerät im Ruhezustand "high" (ca. +5V) so wird die Eingangsdiode des Optokopplers 12 mittels eines Strombegrenzungswiderstandes 30 angesteuert. Folglich wird der Durchgangstransistor des Optokopplers 12 durchgeschaltet. Das führt dazu, daß der Transistor 27b durchgeschaltet und der Transistor 27a blockiert wird. So entsteht die Verbindung zwischen dem Signal 15, RxD am PC, und dem Signal 17 (DTR), das vom PC mit etwa -12V beschaltet ist. Schaltet das Sendesignal TxD im Gerät auf "low" (ca. 0V) so fließt kein Strom durch die Eingangsdiode des Optokopplers 12 und der Ausgangstransistor ist blockiert. In diesem Fall werden die Schalttransistoren 27a und 27b durch den Basis-Versorgungswiderstand 28 so angesteuert, daß der Transistor 27a geöffnet und der Transistor 27b gesperrt ist. So entsteht die Verbindung zwischen dem Signal 15 (RxD am PC) und dem Signal 14 (RTS), das vom PC mit 12V beschaltet ist.

Die Schaltung nach Fig.3 ist geeignet für niedrige Übertragungsgeschwindigkeiten. Um unterschiedliche Verzögerungszeiten der Optokoppler beim Schalten von "low" nach "high" und umgekehrt auszugleichen, kann eine Schaltung nach Fig.4 eingesetzt werden. Bei dieser kommt ein Transistor 29 mit Widerstand 31 hinzu. Der langsame Schaltvorgang beim Blockieren des Optokoppler-Ausgangstransistors wird dadurch beschleunigt, daß der Transistor 29 sofort durchschaltet, wenn die Kollektor-Emitter-Spannung des Optokoppler-Ausgangs-Transistors etwa 0 Volt erreicht. Zusätzlich kann ein Kondensator 32 die "schnelle" Flanke beim Aufladen durch den Widerstand 28 verlangsamen. Wegen der zusätzlichen Invertierung des Signals mittels des Transistors 29 muß die Ansteuerung der Eingangsdiode des Optokopplers 12 umgepolt werden.

Es sind ähnliche Schaltungen für beide Übertragungsrichtungen auch ohne Optokoppler zu realisieren.

## Patentansprüche

1. Umsetzer für die digitale Datenübertragung zwischen einer elektrischen Schnittstelle eines ersten Gerätes und einer als RS 232 Schnittstelle ausgebildeten elektrischen Schnittstelle eines zweiten Gerätes, wobei die Geräte jeweils unterschiedliche Spannungslevel zur Unterscheidung der beiden logischen Zustände "high" und "low" benutzen, umfassend eine interne Schaltung (23), mit der die Spannungslevel des ersten Gerätes auf die dem Zustand entsprechenden Spannungslevel des zweiten umsetzbar sind, wobei der internen Schaltung zum Umsetzen des niedrigen auf den höheren Spannungslevel der höhere Spannungslevel von einem der beiden Geräte zuführbar ist,
**dadurch gekennzeichnet, daß** der internen Schaltung (23) durch Programmierung des zweiten Gerätes über den "Request to Send" Ausgang der RS 232 Schnittstelle ein Spannungslevel von +12 Volt und über den "Data Terminal Ready" Ausgang der RS 232 Schnittstelle ein Spannungslevel von -12 Volt zugeführt wird, und
daß die interne Schaltung (23) ein versorgungsspannnungsunabhängiges Schaltglied (13a, 13b) aufweist, das durch den Zustand der Datenleitung (11) des ersten Gerätes steuerbar ist und das je nach logischem Zustand der Datenleitung (11) eine der beiden von dem zweiten Gerät zugeführten Leitungen, "Request to Send" (14) oder "Data Terminal Ready" (17), auf den Dateneingang (15) der RS 232 Schnittstelle des zweiten Gerätes durchschaltet.

2. Umsetzer nach Anspruch 1,
**dadurch gekennzeichnet, daß** die interne Schaltung (23) das Umsetzen durch einen Schaltvorgang bewerkstelligt.

3. Umsetzer nach Anspruch 1 oder 2,
**dadurch gekennzeichnet, daß** die interne Schaltung (23) Signallevel von etwa 0 Volt oder etwa +5 Volt der TTL-Norm auf Signallevel von etwa -12 Volt oder etwa +12 Volt der Norm RS 232 umsetzt.

4. Umsetzer nach einem der vorherigen Ansprüche,
**dadurch gekennzeichnet, daß** die interne Schaltung (23) in einem Kopplungsstück mit einem Gehäuse (10a) untergebracht ist, das als Stecker auf die elektrische Schnittstelle von einem der beiden Geräte aufsetzbar ist.

5. Umsetzer nach Anspruch 4,
**dadurch gekennzeichnet, daß** an dem Kopplungsstück (10) ein Kabel (8) zur Datenleitung angebracht ist, das die Verbindung zur elektrische Schnittstelle des anderen Gerätes ermöglicht.

6. Umsetzer nach einem der Ansprüche 1 bis 3,
**dadurch gekennzeichnet, daß** die interne Schaltung (23) in einem der beiden Geräte untergebracht ist.

7. Umsetzer nach einem der vorherigen Ansprüche,
**dadurch gekennzeichnet, daß** das Schaltglied zwei Eingänge und einen Ausgang hat, wobei die Eingänge mit den auf +/- 12 Volt liegenden Ausgangsleitungen der RS 232 Schnittstelle und der Ausgang mit der Datentransferleitung verbunden ist.

8. Umsetzer nach einem der vorherigen Ansprüche,
**dadurch gekennzeichnet, daß** die interne Schaltung (23) ein Koppelglied (12) aufweist, das eine galvanische Trennung des ersten und des zweiten Gerätes bewirkt.

9. Umsetzer nach Anspruch 8,
**dadurch gekennzeichnet, daß** das Koppelglied (12) ein Optokoppler ist.

10. Umsetzer nach einem der vorherigen Ansprüche,
**dadurch gekennzeichnet, daß** die interne Schaltung ein Transformationselement (19), insbesondere einen Optokoppler enthält, das eine Eingangsspannung von etwa +12 Volt auf etwa 0 Volt herabsetzt.

11. Umsetzer nach Anspruch 10,
**dadurch gekennzeichnet, daß** die interne Schaltung (23) eingangsseitig ein Sperrglied (21), insbesondere eine Diode enthält, das eine Eingangsspannung von etwa -12 Volt auf etwa +5 Volt umsetzt.

12. Umsetzer nach einem der vorherigen Ansprüche,
**dadurch gekennzeichnet, daß** das erste Gerät eine speicherprogrammierbare Steuerung mit einer Recheneinheit, insbesondere einem Microcontroler, einem Display (6), einer Bedieneinheit (4,5), mit Signaleingängen (2), mit einer elektrischen Schnittstelle (9) und mit Signalausgängen (3) ist, wobei die Recheneinheit, der Bildschirm (6), die Bedieneinheit (4,5), die Signaleingänge (2) und die Signalausgänge (3) in einem gemeinsamen Gehäuse (1) untergebracht sind und wobei das zweite Gerät eine Rechenanlage (7) mit einer elektrischen Schnittstelle RS 232 ist.

## Claims

1. Converter for the digital data transmission between an electrical interface of a first device and an electrical interface - designed as an RS 232 interface - of a second device, the devices in each case using different voltage levels for differentiating between the two logic states "high" and "low", comprising an internal circuit (23), with which the voltage level of the first device can be converted to the voltage level - corresponding to the state - of the second device, it being possible to feed the higher voltage level from one of the two devices to the internal circuit for converting the low to the higher voltage level,
**characterized in that** there are fed to the internal circuit (23), by programming of the second device, a voltage level of +12 volts via the "request to send" output of the RS 232 interface and a voltage level of -12 volts via the "data terminal ready" output of the RS 232 interface, and
**in that** the internal circuit (23) has a supply-voltage-independent switching element (13a, 13b), which can be controlled by the state of the data line (11) of the first device and, depending on the logic state of the data line (11), through-connects one of the two lines fed from the second device, "request to send" (14) or "data terminal ready" (17), to the data input (15) of the RS 232 interface of the second device.

2. Converter according to Claim 1,
**characterized in that** the internal circuit (23) realizes the conversion by a switching operation.

3. Converter according to Claim 1 or 2,
**characterized in that** the internal circuit (23) converts signal levels of about 0 volts or about +5 volts of the TTL standard to signal levels of about -12 volts or about +12 volts of the RS 232 standard.

4. Converter according to one of the preceding claims,
**characterized in that** the internal circuit (23) is accommodated in a coupling piece with a housing (10a), which can be placed as a connector onto the electrical interface of one of the two devices.

5. Converter according to Claim 4,
**characterized in that** a cable (8) for conducting data is fitted to the coupling piece (10), and enables the connection to the electrical interface of the other device.

6. Converter according to one of Claims 1 to 3,
**characterized in that** the internal circuit (23) is accommodated in one of the two devices.

7. Converter according to one of the preceding claims,
**characterized in that** the switching element has two inputs and an output, the inputs being connected to the output lines of the RS 232 interface, which lines are at +/-12 volts, and the output being connected to the data transfer line.

8. Converter according to one of the preceding claims,
**characterized in that** the internal circuit (23) has a coupling element (12), which effects direct electrical isolation of the first and second devices.

9. Converter according to Claim 8,
**characterized in that** the coupling element (12) is an optocoupler.

10. Converter according to one of the preceding claims,
**characterized in that** the internal circuit contains a transformation element (19), in particular an optocoupler, which reduces an input voltage from about +12 volts to about 0 volts.

11. Converter according to Claim 10,
**characterized in that** the internal circuit (23) contains, on the input side, a blocking element (21), in particular a diode, which converts an input voltage from about -12 volts to about +5 volts.

12. Converter according to one of the preceding claims,
**characterized in that** the first device is a stored-program controller with a computing unit, in particular a microcontroller, a display (6), an operating unit (4, 5), with signal inputs (2), with an electrical interface (9) and with signal outputs (3), the computing unit, the screen (6), the operating unit (4, 5), the signal inputs (2) and the signal outputs (3) being accommodated in a common housing (1), and the second device being a computing system (7) with an electrical RS 232 interface.

## Revendications

1. Convertisseur pour la transmission numérique de données entre une interface électrique d'un premier appareil et une interface électrique réalisée sous la forme d'une interface RS 232 d'un deuxième appareil, les appareils utilisant chacun des niveaux de tension différents pour différencier les deux états logiques « haut » et « bas », comprenant un circuit interne (23) avec lequel les niveaux de tension du premier appareil peuvent être convertis aux niveaux de tension correspondant à l'état du deuxième appareil, les niveaux de tension plus élevés de l'un des deux appareils pouvant être acheminés au circuit interne pour convertir les niveaux de tension bas en niveaux de tension hauts, **caractérisé en ce qu'**un niveau de tension de +12 volts est acheminé au circuit interne (23) par le biais de la sortie « Request to Send » de l'interface RS 232 et un niveau de tension de -12 volts par le biais de la sortie « Data Terminal Ready » de l'interface RS 232 par programmation du deuxième appareil, et que le circuit interne (23) présente un élément de commutation indépendant de la tension d'alimentation (13a, 13b) qui peut être commandé par l'état de la ligne de données (11) du premier appareil et qui, suivant l'état logique de la ligne de données (11), commute l'une des deux lignes acheminées par le deuxième appareil « Request to Send » (14) ou « Data Terminal Ready » (17) sur l'entrée des données (15) de l'interface RS 232 du deuxième appareil.

2. Convertisseur selon la revendication 1, **caractérisé en ce que** le circuit interne (23) réalise la conversion par un processus de commutation.

3. Convertisseur selon la revendication 1 ou 2, **caractérisé en ce que** le circuit interne (23) convertit les niveaux de signal d'environ 0 volt ou d'environ +5 volts de la norme TTL en des niveaux de signal d'environ -12 volts ou d'environ +12 volts de la norme RS 232.

4. Convertisseur selon l'une des revendications précédentes, **caractérisé en ce que** le circuit interne (23) comprend un élément de couplage avec un boîtier (10a) qui peut être placé en tant que fiche sur l'interface électrique de l'un des deux appareils.

5. Convertisseur selon la revendication 4, **caractérisé en ce que** l'élément de couplage (10) comprend un câble (8) pour la ligne des données qui permet la liaison avec l'interface électrique de l'autre appareil.

6. Convertisseur selon l'une des revendications 1 à 3, **caractérisé en ce que** le circuit interne (23) est logé dans l'un des deux appareils.

7. Convertisseur selon l'une des revendications précédentes, **caractérisé en ce que** l'élément de commutation possède deux entrées et une sortie, les entrées étant reliées aux lignes de sortie de l'interface RS 232 qui se trouvent à +/- 12 volts et la sortie à la ligne de transfert de données.

8. Convertisseur selon l'une des revendications précédentes, **caractérisé en ce que** le circuit interne (23) présente un élément de couplage (12) qui réalise une isolation galvanique du premier et du deuxième appareil.

9. Convertisseur selon la revendication 8, **caractérisé en ce que** l'élément de couplage (12) est un opto-coupleur.

10. Convertisseur selon l'une des revendications précédentes, **caractérisé en ce que** le circuit interne contient un élément de transformation (19), plus précisément un opto-coupleur, qui abaisse une tension d'entrée d'environ +12 volts à environ 0 volt.

11. Convertisseur selon la revendication 10, **caractérisé en ce que** le circuit interne (23) contient du côté de l'entrée un élément de blocage (21), plus précisément une diode, qui convertit une tension d'entrée d'environ -12 volts en une tension d'environ +5 volts.

12. Convertisseur selon l'une des revendications précédentes, **caractérisé en ce que** le premier appareil est une commande numérique programmable composée d'un calculateur, plus précisément un microcontrôleur, d'un afficheur (6), d'une unité de commande (4, 5), d'entrées signal (2), d'une interface électrique (9) et de sorties signal (3), le calculateur, l'écran (6), l'unité de commande (4, 5), les entrées signal (2) et les sorties signal (3) étant logés dans un boîtier commun (1) et le deuxième appareil étant un ordinateur (7) muni d'une interface électrique RS 232.
